# EUROPEAN PATENT APPLICATION

(11) **EP 3 057 124 A1**
(43) Date of publication of application: **17.08.2016**
(21) Application number: 16155503.2
(22) Date of filing: 12.02.2016
(51) Int. Cl.: H01L 23/04, H01L 23/31, H01L 23/66

(54) **RF PACKAGE**

(30) Priority: 12.02.2015 US 201514620601
(71) Applicant: Ampleon Netherlands B.V., 6534 AV Nijmegen (NL)
(72) Inventor: Weinschenk, Christian, 6534 AE NIJMEGEN (NL)
(74) Representative: Nollen, Maarten Dirk-Johan

(57) **Abstract**

An example package comprising: an RF circuit having a first portion and a second portion; a cavity structure positioned only over the first portion of the RF circuit; and an encapsulant material coupled to cover the RF circuit and cavity structure on at least one side of the RF circuit. An example method of package manufacture, comprising: identifying an RF circuit; forming a cavity structure upon the RF circuit, wherein at least a portion of the cavity structure has a height based on a level of magnetic field in the RF circuit; and covering the RF circuit and cavity structure with an encapsulant material on at least one side of the RF circuit.

## Description

### Field of the invention

The invention relates to a package comprising an RF circuit and an encapsulation to cover the RF circuit.
The invention further relates to a method of manufacturing such an RF circuit.

### Background of the invention

As electrical circuits and devices are reduced in size, resistance and capacitive coupling increase, causing an increase in signal delay (i.e. RC delay) and other electrical losses. This becomes an increasing problem as an electrical circuit's operating frequency increases (e.g. for RF circuits and devices) which further limits the circuit's performance.

RF circuits that are particularly sensitive for losses of RF performance are RF power amplifiers. These RF power amplifiers typically contain a semiconductor die with active elements, such as transistors. The power amplifier may further contain impedance matching components, such as capacitors and/or inductive elements, for matching the impedance at an output of the transistor. While typically the amplifier contains several parts, it may be that the amplifier is functionally a single element. It is further feasible that the amplifier comprises several stages.

The transistor design of an RF power amplifier is optimized for use at high frequencies, for instance above 1GHz and suitably extending in the range up to 3 GHz and higher and also at relatively high power levels. Such a power transistor may be a field effect transistor or a bipolar transistor and is made in technologies such as Si LDMOS, GaN or GaAs. Typically, a first and a second electrode, for instance drain and gate, are implemented as a plurality of elongated bars that are arranged in parallel. A third electrode, which is for instance the source, is coupled to the substrate and an underlying substrate contact. The number of elongated bars may be significant, for instance in the range of 10-300, for instance 30-250, typically 50 or more or 100 or more. The elongated bars of are typically coupled via internal wiring to bond pads that are arranged at a top side of the semiconductor die and in the outer ring thereof. These bond pads are exposed through an opening in a passivation layer. While many integrated circuits contain many internal wirings that are present in several interconnect layers, the number of interconnect layers is typically limited to 1 or 2 in RF power amplifiers, due to the fact that there is only limited interconnection and that the effective feature size of the RF transistor is relatively big so as to enable sufficient heat dissipation.

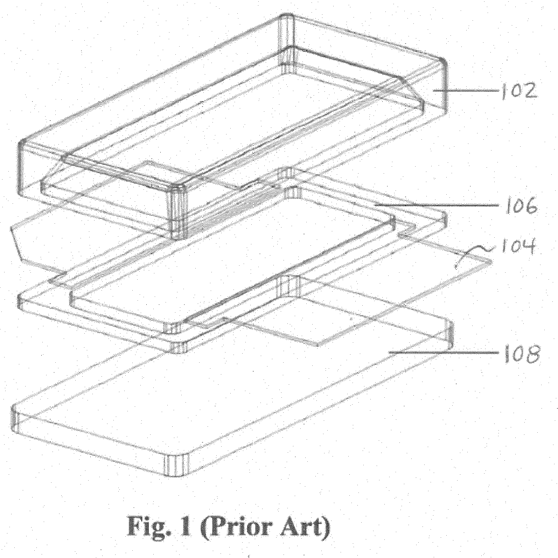

Traditionally, RF power amplifiers are present in air cavity package 100 as shown in Figure 1. The package 100 includes a lid with open cavity 102, a lead frame 104, a dielectric ring 106 and a heat sink 108. The air cavity package 100 is built-up by stacking these elements, which thereby encapsulate a semiconductor die, internal wiring and an air cavity. Epoxy glues are used to hold these elements together. More particularly, the semiconductor die is attached with its bottom side to the heat sink. Bond pads are present at a top side of the semiconductor die. Bond wires extend between the bond pads and individual leads of the leadframe 104.

The function of the air cavity is to provide a robust package on top of the RF die. Because of the absence of any encapsulant, the thermal stability of such encapsulant during operation of the power amplifier is not an issue. Furthermore, air is a dielectric with low dielectric constant (e.g. *k* close 1.0). As a consequence, interaction between the wire loops of bond wires can be minimized. Hence, the wire loops can be designed and used as part of an input shunt inductance and/or as part of an output circuit for impedance matching. Thus all-in-all reduces electrical losses and enhances the performance of the RF product and system. The dielectric constant (k) is a measure of how easily a material is polarized in an external electric field.

A disadvantage of the known air cavity package is the use of a dielectric ring and lid. The dielectric ring (106) should be fixed to the heat sink (108) before wire bonds are provided The lid should be fixed to the package after that bond wires are provided. The placement and attachment is cumbersome at that stage, resulting in a high cost. Furthermore, the lid can be removed easily by clients or users. That removal may result in malfunctioning of the RF circuit, which is not desired.

As an alternative to the use of an air cavity package with a lid, it is known to apply an encapsulant by moulding. The RF circuit becomes fully encapsulated in the moulded encapsulant (also known as a moulding compound). Merely the leads and the heatsink are present at the outside of the package. This type of package is very well known in the field of semiconductor packaging and further provides a very good protection against humidity, dust and environmental conditions. However, a moulding compound typically includes fillers such as glass fibers, which contribute to the dielectric constant of the package material, which is undesired for the performance of the RF circuit.

### Summary

According to an example embodiment, a package includes: an RF circuit having a first portion and a second portion; a cavity structure positioned only over the first portion of the RF circuit; and an encapsulant material coupled to cover the RF circuit and cavity structure on at least one side of the RF circuit.

In another example embodiment, the first portion of the circuit includes active elements, such as the one or more power transistors of the RF power amplifier; and the second portion of the circuit includes passive elements. The passive elements may be embodied in the same semiconductor die as the active elements. Alternatively or additionally, the passive elements are embodied in a separate die and/or are embodied as discrete elements, including bond wires. If the semiconductor die does not contain passive elements, the second portion is more particularly an outer ring in which bond pads are defined. As such the cavity structure is arranged to leave the bond pads free. This is particularly desired for RF power amplifiers, since the bond wires are typically provided with a predefined length so as to arrive at a correct impedance.

In another example embodiment, the RF circuit includes a device operating at a frequency of at least 1GHz, more particularly at least in the range of 1.8-2.8 GHz. For such frequencies, moreover the performance losses due to the interaction in the magnetic field with the dielectric material of a conventional moulding compound have found to be so significant that they will have an impact on the RF performance, particularly in the case wherein the RF circuit primarily consists of an RF power amplifier.

In another example embodiment, the cavity structure includes a height based on a level of magnetic field in the RF circuit. Preferably, the height is at least 20µm. This height is desired to contain at least 80% of the magnetic field originating from the circuit.

In another example embodiment, the cavity structure includes a cover and an adhesive sidewall. The cover is preferably embodied as a semiconductor die. More preferably, the semiconductor die is devoid of any circuits or devices. As a consequence, it is not needed to apply any electrical connection between said second semiconductor die and either the leadframe or the RF circuit. The use of a semiconductor die as a cover is deemed suitable so as to ensure that the encapsulant can fully cover the cavity structure and any bond wires arranged adjacent to the cavity structure. In a further implementation, the top side of the second semiconductor die is provided with an adhesion promotor. Such an adhesion promotor is for instance a layer of silicon nitride or silicon oxide.

In a further embodiment, the second semiconductor die contains functionality. Preferably, such functionality is RF functionality and/or part of the RF circuit. An example is the provision of a shield, so as to limit the vertical extension of the magnetic field extending into the package.

Another example is the use of the second semiconductor die as an intermediate heat sink, that is or can be coupled to an external source (outside the package) via a heat conductive path. In such an event one or more suitable connections will be present between the first die and the second die and/or to one or more leads of the lead frame.

Suitably, the adhesive side wall is applied to either the - first - semiconductor die or the second semiconductor die or to both of them prior to dicing of the semiconductor dies out of a semiconductor substrate. In one embodiment, an adhesive layer is applied on a rear side of the second semiconductor die in a process known in the field of assembly as a wafer back coating or a wafer back laminate. The adhesive layer may be applied to the rear side of the second semiconductor die according to a predefined pattern. More preferably, a further adhesive layer is applied on the top side of the first semiconductor die. By combining two adhesive layers, the total height of the adhesive side wall may be increased, so as to create a cavity.

In another example embodiment, the package further comprising a lead-frame and a set of bond-wires; and a first bond-wire couples the RF circuit to the lead-frame; the cavity structure completely covers a second bond-wire; and the encapsulant further covers the first bond-wire, the second bond-wire and a portion of the lead-frame.

In another example embodiment, the package further comprising a second circuit completely covered by the cavity structure; and the second bond-wire couples the RF circuit to the second circuit.

In another example embodiment, the RF circuit is a single semiconductor die.

In another example embodiment, the encapsulant material is coupled to encapsulate the RF circuit and cavity structure.

An example method embodiment for package manufacture includes: identifying an RF circuit; forming a cavity structure upon the RF circuit, wherein at least a portion of the cavity structure includes a height based on a level of magnetic field in the RF circuit; and covering the RF circuit and cavity structure with an encapsulant material on at least one side of the RF circuit.

In one embodiment of the method, the cavity structure is formed upon the RF circuit after the RF circuit has been diced and affixed to a substrate. In another example method embodiment, the cavity structure is formed upon the RF circuit after bond-wires have coupled the RF circuit to a lead-frame. Alternatively, the cavity structure may be formed upon the RF circuit prior to dicing. However, it is deemed preferable to apply the cavity structure after coupling bond wires to the leadframe. In this manner, the distance between the bond wires and the side walls of the cavity structure can be kept to a minimum. This is beneficial, as an increase in size of the die results in an increase in cost price. In the alternative, the cavity structure should have been reduced in size, which however limits its usefulness.

In another example method embodiment, the circuit includes active elements and passive elements; the cavity structure does not cover all of the passive elements; and the encapsulant material does cover all of the active and passive elements.

In another example method embodiment, the sidewalls of the cavity structure are applied as a liquid.

In another example method embodiment, the height of the cavity structure is greater than 20µm.

Various example embodiments may be more completely understood in consideration of the following Detailed Description in connection with the accompanying Drawings, in which:

### Brief description of the drawings

Figure 1 is an air cavity package.
Figure 2 shows a first example RF package.
Figure 3 shows an encapsulated version of the first example RF package.
Figure 4 shows a second example RF package.
Figure 5 shows a third example RF package.
Figures 6A and 6B show a fourth example RF package.
Figure 7 is an example method for fabricating an RF package.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

### Detailed description

In RF systems, semiconductor packages for RF amplifiers or RFIC's can be made by means of over-molding such that the dies and wires are covered by mold compound. Examples of this art are the QFN, HSOP and BGA package styles.

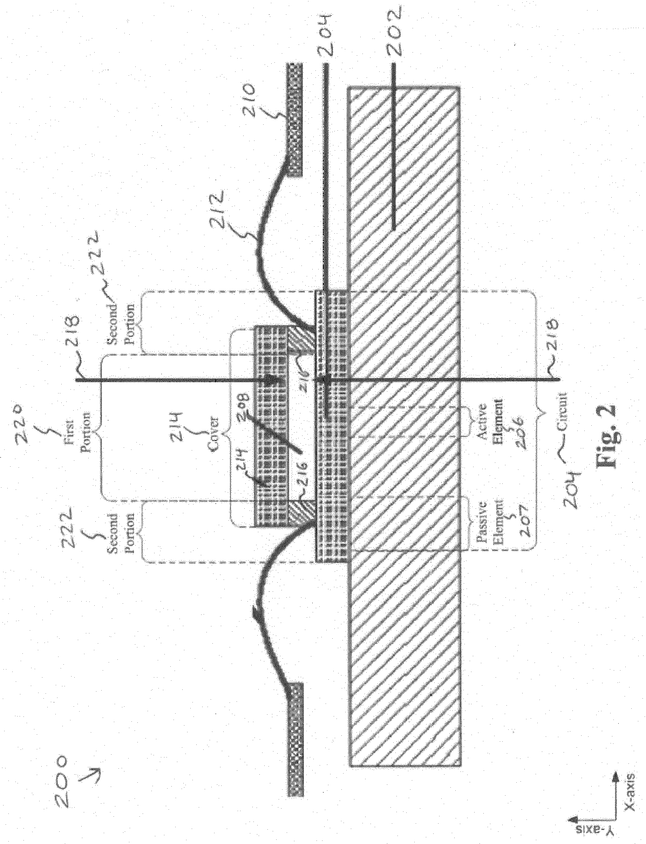

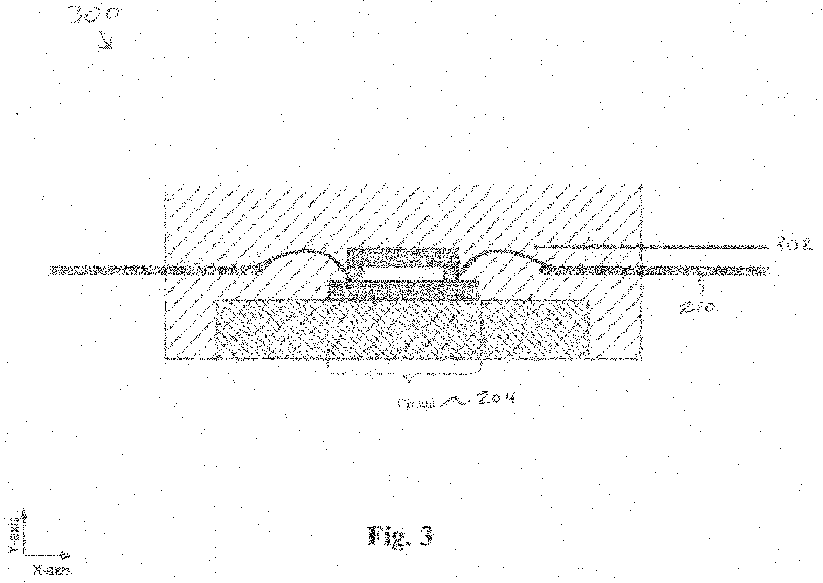

Figure 2 shows a first example RF package 200. Figure 3 shows an encapsulated version 300 of the first example RF package 200. Figures 2 and 3 will be discussed together.

The RF circuit package 200 includes a substrate 202 (e.g. heat sink) upon which a circuit 204 (e.g. die) is affixed (e.g. bonded). In one example, the circuit 204 includes one or more active elements 206 and passive elements 207. A cavity structure 208 is formed (e.g. localized) over at least one of the active elements 206. The cavity structure 208 includes a cover 214 (e.g. lid) and a set of sidewalls 216 (e.g. adhesive walls or beads of glue) which together provide the cavity structure 208 with a lateral height 218. The height 218 formed is based on a level of magnetic field in the RF circuit 204 and based on controlling electrical losses related thereto.

In example embodiments the height 218 ranges from 20µm to 100µm. However in other embodiments, the height of the cavity structure 208 can be less than 20µm, or higher than 100µm. Higher cavity structures 208 further reduce electrical losses due to electrical fields created by the RF circuit and associated circuit leads and/or bond-wires 212. Selection of the lateral height depends upon a maximum acceptable magnetic field disturbance caused by the encapsulant 302, within the RF circuit's 204 operational range of frequencies. Thus, the lateral dimensions of the cavity structure 208 depends on the dimensions of the size of the active elements 206, the passive elements 207 and the circuit 204 being covered.

The circuit 204 is connected to a lead-frame 210 by one or more bond-wires 212. In one example an encapsulant material 302 (e.g. molding compound) covers the entire circuit 204, cavity structure 208, bond-wires 212 and at least part of the lead-frame 210. In other examples, the encapsulant material 302 may cover only part or one side of: the circuit 204, the cavity structure 208 and/or the bond-wires 212.

In various examples: the circuit 204 includes active elements 206 and passive elements 207; or the cavity structure 208 does not cover all of the passive elements 207, but may cover some or all of the active elements 206.

The function of the cavity structure 208 is to provide a low dielectric constant (as close to 1.0 as possible) over one or more active elements 206 in the circuit 204. In one example embodiment, the dielectric constant of the cavity structure 208 is lower than that of the encapsulant material 302 (3.5-4.0).

The cavity structure 208 can be formed over one or more of the elements 206, 207 or circuits 204, before or after the circuits 204 are attached (e.g. bonded) to the substrate 202.

The phrase "active element" 206 can have different meanings, but in this case at least refers to amplification elements, including transistors/mosfets and any other amplification device.

"Passive elements" 207 are hereby defined as any other electrical element which is not an active element 206 (e.g. capacitors, resistors, inductors, bond-wire 212 pads, wires, etc.).

To reiterate, the cavity structure 208 can be placed just over the active elements 206; placed over both active elements 206 and passive elements 207; and/or placed over the bond-wires 212 to reduce electrical losses even further and thereby further enhance the performance of the RF device.

Other examples further include a lead-frame 210 and a set of bond-wires 212. Then: a first bond-wire 212 couples the circuit 204 to the lead-frame 210; the cavity structure 208 completely or partially covers a second bond-wire 212; and the encapsulant material 302 further covers the first bond-wire 212, the second bond-wire 212 and a portion of the lead-frame 210.

In example embodiments having a second circuit 204, the second bond-wire 212 in one example couples the RF circuit 204 to the second circuit 204. In such examples having multiple circuits 202, such circuits 204 may be interconnected with bond-wires 212 and placed within a single lead-frame 210. In such an example, not all of the package's 200 bond-wires 212 may be coupled to the lead-frame 210, since some of the bond-wires 212 are interconnecting the different circuits 204 within the package 200.

The RF circuit 204 can be a device operating at a frequency of at least 1GHz, but in some example may be as low as 100MHz. The circuit 204 may also be wholly embodied in a semiconductor die.

The encapsulant material 302 can be coupled to encapsulate the RF circuit 204 and cavity structure 208. Figure 3 shows an example where the substrate 202 could be a heat-sink, one side of which is left exposed for effective circuit 204 cooling, and the other sides covered by the encapsulant material 302.

Alternate example embodiments of the package 200 can include: an RF circuit 204 having a first portion 220 and a second portion 222; a cavity structure 208 placed over only the first portion 220 of the RF circuit 204; and an encapsulant material 302 coupled to cover the RF circuit 204 and cavity structure on at least one side of the RF circuit 204.

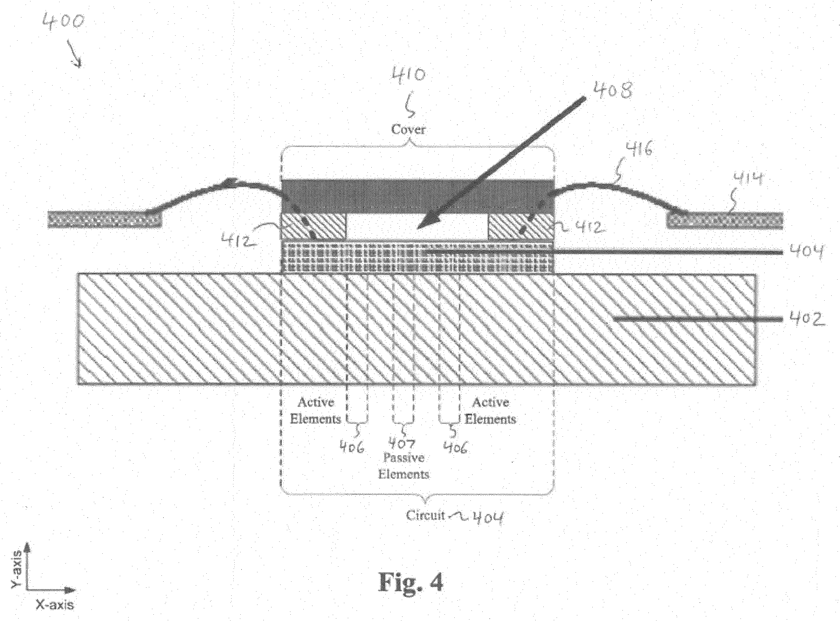

Figure 4 shows a second example RF package 400. In this example a cavity structure 408 covers almost an entire surface of the circuit 404, including both the active elements 406 and a passive element 407. In other example embodiments, passive elements in the circuit 404 can include the remainder of the circuit 404 which may include empty areas with no electrical or mechanical elements.

While the cover 410 extends the width of the circuit 404 in the Figure 4 example embodiment, the sidewalls 412 rest on the circuit's 404 perimeter or edges. In other example embodiments the sidewalls 412 can be placed over the bond-wires 416 using Film over Wire (FOW) techniques, so that the cavity structure 408 could extend over the entire width of the circuit 404.

Encapsulant would then be applied to cover all or part of the cavity structure 402, the circuit 404, the substrate 402, the bond-wires 416 and the lead-frame 414.

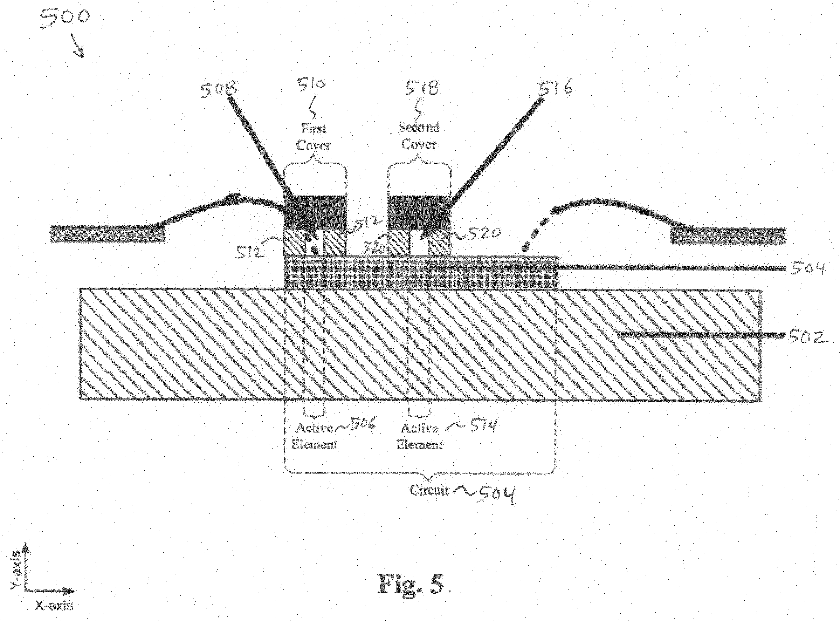

Figure 5 shows a third example RF package 500. The package 500 includes a first active element 506, covered by a first cavity structure 508, and a second active element 514, covered by a second cavity structure 516. The first cavity structure 508 includes a first cover 510 and a first set of sidewalls 512. The second cavity structure 516 includes a second cover 518 and a second set of sidewalls 520.

The remainder of the circuit 504 may or may not include additional active or passive elements. Encapsulant would then be applied to cover all or part of the cavity structures 508, 516, the circuit 504, the substrate 502, the bond-wires and the lead-frame.

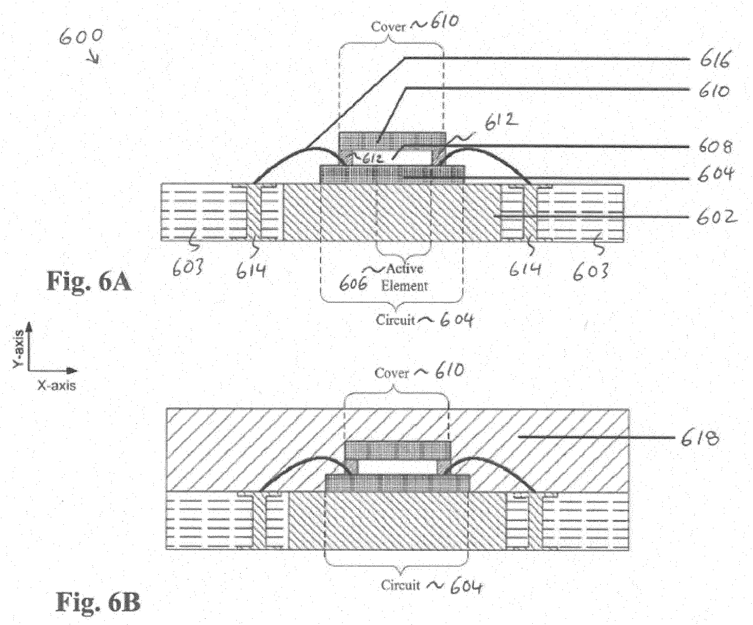

Figures 6A and 6B show a fourth example RF package 600. The package 600 includes a heatsink 602 upon which a circuit 604 is affixed. In one example, the circuit 604 includes one or more active elements 606 and passive elements. A cavity structure 608, including a cover 610 and set of sidewalls 612, is placed over at least one of the active elements 606.

The heatsink 602 and one or more terminals 614 (e.g. pin, via or contact) are embedded in a laminate substrate 603.

The circuit 604 is connected to the terminals 610 by one or more bond-wires 616. In one example an encapsulant material 618 covers the entire circuit 604, cavity structure 608, bond-wires 616 and at least one of the terminals 614. In other examples, the encapsulant material 618 may cover only part of the circuit 604, cavity structure 608 and bond-wires 616. The laminate 603 can be an organic material based substrate.

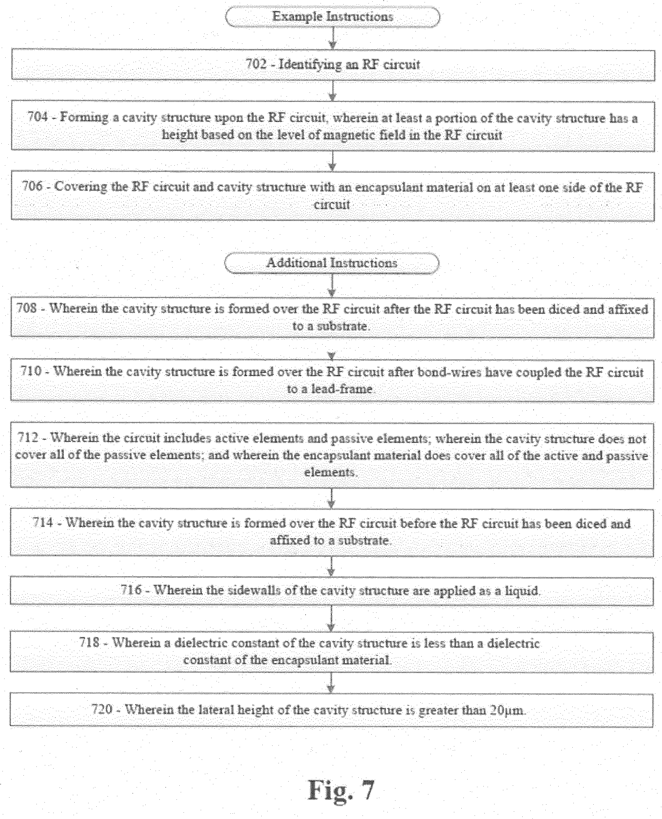

Figure 7 is an example method for fabricating an RF package. The order in which the instructions are discussed does not limit the order in which other example embodiments implement the instructions. Additionally, in some embodiments the instructions are implemented concurrently.

A first example instruction begins in 702, by identifying an RF circuit. Next, in 704, forming a cavity structure upon the RF circuit, wherein at least a portion of the cavity structure has a height based on the level of magnetic field in the RF circuit. Then in 706, covering the RF circuit and cavity structure with an encapsulant material on at least one side of the RF circuit.

The instructions can be augmented with one or more of the following additional instructions, presented in no particular order. The additional instructions include: 708 - wherein the cavity structure is formed over the RF circuit after the RF circuit has been diced and affixed to a substrate. 710 - wherein the cavity structure is formed over the RF circuit after bond-wires have coupled the RF circuit to a lead-frame. 712 - wherein the circuit includes active elements and passive elements; wherein the cavity structure does not cover all of the passive elements; and wherein the encapsulant material does cover all of the active and passive elements. 714 - wherein the cavity structure is formed over the RF circuit before the RF circuit has been diced and affixed to a substrate. 716 - wherein the sidewalls of the cavity structure are applied as a liquid. Note that during the patterned WBC (wafer backside coating) process, the glue is not necessarily a liquid at the moment it will be attached to the RF circuit 204. Instead an epoxy adhesive can be pre-cured after application on the backside of a wafer, which will be used for the lids 214. After pre-curing the WBC it is already dry at the surface 718 - wherein a dielectric constant of the cavity structure is less than a dielectric constant of the encapsulant material 720 - wherein the lateral height of the cavity structure is greater than 20µm.

An alternate example method for fabricating an RF package is now presented. Front-end die 204 processing is first completed, before the cover 214 is applied to avoid excessive temperatures.

Next, attach the die 204 to a heat-sink 202 (bonded with solder at medium heat 300-400 ). Then, wire-bond 212 die 204 to lead-frame 210. If needed, the direction of wire bonding can be adapted to lower the wire height over the RF die 204 to enable a larger film over wire area, as will be further discussed below.

There are at least two options for applying the glue 216. In a first option, the glue 216 is applied to the die 204 first. In a second option, the glue 216 is applied to the cover 214 first.

In the First Option, the glue 216 is patterned around an active RF region 206 of the die 204. The glue 216 is patterned on the die 204 with quite some thickness using a high viscosity glue. In one example embodiment, use of a non-conductive glue 216 avoids unwanted electrical connections between die 204 elements and can be applied over the bond-wires 212 and other metal structures. Conductive glues 216 would need to be more carefully placed on the die 204 to avoid unwanted electrical connections. The glue/adhesive 216 can be placed over wires, using Film over Wire (FOW) techniques. This can be advantageous when wire bond pads are very close to the active area 206. Commercially available FOW materials are optimized to limit TCE differences with molding compound.

Next the cover 214 is created. The lateral thickness of the cover 214 is based on several factors including, but not limited to, the size of the active area 206 on the RF die 204 and the applied pressure during the over molding process. A typical cover 214 thickness is in the range of 50-300 µm, preferably in the order of 100-200µm. The cover 214 material is silicon in one embodiment, however in alternate embodiments could be a ceramic, organic or metallic material.

In an example where the cover 214 is made of silicon, the wafer is patterned into cover structures. As mentioned above, if the second option is selected, the glue 216 is applied to the cover 214, instead of the die 204, first. The glue sidewalls 216 can be applied to the cover 214 using wafer backside coating (WBC) techniques. Applying adhesive using WBC in combination with stencil printing results into well-defined adhesive patterns on the wafer. The width and height of the adhesive wall will be constrained by the stencil printing process (i.e. minimum stencil aperture aspect ratio).

Next the covers 214 are diced from the wafer. Then, for Option 1, the covers 214 are placed on top of the glue 216 surrounding the active circuit 206 on the RF die 204 using standard die attach processes, (i.e. a process similar to normal die-bonding). For Option 2, the glue 216 and cover 214 combination are then placed over the active circuit 206 on the RF die 204, using standard die attach processes.

Then the cover 214 and glue 216 are bonded to the die 204 in a medium heat curing step. Bonding the cover onto the RF die 204 will result into slightly shrunk adhesive walls. After cover 214 and glue 216 bonding, the RF circuit package 200 is over molded/encapsulated.

The instructions and/or flowchart steps discussed above can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

## Claims

1. A package comprising:
an RF circuit includes an amplifier device operating at a frequency of at least 1GHz and having a first portion and a second portion;
a cavity structure positioned only over the first portion of the RF circuit; and
an encapsulant material coupled to cover the RF circuit and cavity structure on at least one side of the RF circuit.

2. The package of claim 1:
wherein the first portion of the circuit includes active elements; and
wherein the second portion of the circuit includes passive elements.

3. The package of claim 1-2:
wherein the cavity structure includes a height based on a level of magnetic field in the RF circuit, and preferably is at least 20 µm.

4. The package of claim 1-3, wherein the cavity structure includes a cover and an adhesive sidewall.

5. The package of claim 4, wherein the cover is a semiconductor die

6. The package of claim 1-5, further comprising a lead-frame and a set of bond-wires;
wherein a first bond-wire couples the RF circuit to the lead-frame;
wherein the cavity structure completely covers a second bond-wire; and
wherein the encapsulant further covers the first bond-wire, the second bond-wire and a portion of the lead-frame.

7. The package of claim 6, further comprising a second circuit completely covered by the cavity structure; and wherein the second bond-wire couples the RF circuit to the second circuit.

8. The package of claim 1, wherein the RF circuit is a single semiconductor die.

9. The package of claim 1, wherein the encapsulant material is coupled to encapsulate the RF circuit and cavity structure.

10. A method of package manufacture, comprising:
identifying an RF circuit;
forming a cavity structure upon the RF circuit, wherein at least a portion of the cavity structure has a height based on a level of magnetic field in the RF circuit, which is preferably at least 20 µm; and
covering the RF circuit and cavity structure with an encapsulant material on at least one side of the RF circuit.

11. The method of claim 10, wherein the cavity structure comprises an adhesive wall and a cover with a rear side, wherein the adhesive wall is formed by joining a first adhesive layer applied to the rear side of the cover and a second adhesive layer applied to a top side of a semiconductor die embodying the RF circuit or part thereof.

12. The method as claimed in claim 11, wherein the cavity structure is formed upon the RF circuit after the RF circuit has been diced and affixed to a substrate, and wherein the cavity structure is formed upon the RF circuit after bond-wires have coupled the RF circuit to a lead-frame.

13. The method of claim 12, wherein the forming of the cavity structure comprises the steps of applying the second adhesive layer according to a predefined pattern to the first semiconductor die, and joining the first and second adhesive layer.

14. The method as claimed in any of the claims 10-13, wherein the circuit includes active elements and passive elements;
wherein the cavity structure does not cover all of the passive elements; and
wherein the encapsulant material does cover all of the active and passive elements.

15. The method of claim 10-14, wherein the sidewalls of the cavity structure are applied as a liquid.
